Europäisches Patentamt

European Patent Office

Office européen des brevets

(11) Publication number: **0 328 970 B1**

## EUROPEAN PATENT SPECIFICATION

(45) Date of publication of patent specification: **17.08.94**

(51) Int. Cl.5: **C23C 16/04**, H01L 21/285, H01L 29/76, C23C 16/14, H01L 21/90

(21) Application number: **89101923.4**

(22) Date of filing: **03.02.89**

(54) Method of depositing tungsten on silicon in a non-self-limiting CVD process and semi-conductor device manufactured thereby.

(30) Priority: **18.02.88 US 157026**

(43) Date of publication of application:
**23.08.89 Bulletin 89/34**

(45) Publication of the grant of the patent:
**17.08.94 Bulletin 94/33**

(84) Designated Contracting States:
**CH DE ES FR GB IT LI NL SE**

(56) References cited:
**EP-A- 0 139 467**
**EP-A- 0 147 913**
**FR-A- 2 590 407**

**EXTENDEX ABSTRACTS OF THE 20TH (1988 INTERNATIONAL) CONFERENCE ON SOLID STATE DEVICES AND MATERIALS 24-26 August 1988, pages 85-88, Tokyo, JP; N. KOBAYASHI et al.: "Tungsten Plug Technology: Substituting Tungsten for Silicon Using Tungsten Hexaflouride"**

(73) Proprietor: **International Business Machines Corporation**
**Old Orchard Road**
**Armonk, N.Y. 10504 (US)**

(72) Inventor: **Joshi, Rajiv V.**
**4-1 Woodbrock Lane**
**Yorktown Heights, N.Y. 10598 (US)**

(74) Representative: **Mönig, Anton, Dipl.-Ing.**
**IBM Deutschland Informationssysteme GmbH,**
**Patentwesen und Urheberrecht**
**D-70548 Stuttgart (DE)**

EP 0 328 970 B1

JOURNAL OF THE ELECTROCHEMICAL SOCI-
ETY, vol. 134, no. 8A, August 1987, pages
2061-2067, Manchester, NH, US; N. LIFSHITZ
et al.: "Selective Molybdenum Deposition by
LPCVD"

SOLID STATE TECHNOLOGY, vol. 27, no. 8,
August 1984, pages 145-149, Port Washing-
ton, New York , US; J.Y, CHEN et al.: "Refrac-
tory Metals and Metal Silicides for VLSI
Sevices"

PATENT ABSTRACTS OF JAPAN, vol. 10, no.
170 (E-412), 17 June 1986; & JP-A-61 022 651

JOURNAL OF THE ELECTROCHEMICAL SOCI-
ETY, vol. 134, no. 9, September 1987, pages
2339-2345, Manchester, NH, US; M. WONG et
al.: "The Effects of Chemical Oxide on the
Deposition of Tungsten by the Silicon Re-
duction of Tungsten Hexafluoride"

JOURNAL OF THE ELECTROCHEMICAL SOCI-
ETY, vol. 133, no. 6, June 1986,pages
1195-1200, Manchester, NH, US; H.H. BUSTA
et al.: "Film Thickness Dependence of Sili-
con Reduced LPCVD Tungsten on Native
Oxide Thickness"

**Description**

This invention generally relates to the deposition of metal layers on a substrate and more particularly to CVD methods for selectively converting silicon to tungsten and to MOS semiconductor devices formed thereby.

In the manufacture of semiconductor devices there is a continuing desire to increase device density on the semiconductor chips in order to increase the resulting operating speeds of the device. The tight packing of devices on the chips places a premium on manufacturing techniques to meet the high standards of reliability necessary for such devices. In the manufacture of MOS devices, there has been considerable investigation of the deposition of refractory metals, such as tungsten and molybdenum. Refractory metals have excellent diffusion barrier properties and low contact resistance with silicon.

Presently, selective deposition of tungsten is performed by silicon and hydrogen reduction of tungsten hexafluoride gas. It is well known that tungsten may be deposited by only silicon reduction of tungsten hexafluoride according to the following equation:

$$2WF_6 + 3Si \rightarrow 2W + 3SiF_4 \uparrow$$

The prior art has taught, however, that silicon reduction is self-limiting and results in encroachment problems. The addition of hydrogen reduction is used to deposit tungsten in the desired thickness. The hydrogen reduction method, however, also results in severe encroachment problems. In addition, the selectivity in depositing tungsten strictly depends on the predeposition condition of the wafer, deposition chamber design, vacuum capability, the method of heating the substrate, and elaborate bake and purge cycles. Poor reproduceability, slow growth rates at turret temperatures below 400°C. (less than 10 nm per minute), and selectivity breakdown are the major drawbacks of this process. In addition, HF liberated in the hydrogen reduction process etches recess oxide isolation areas of the devices, resulting in penetration of tungsten hexafluoride along the oxide edges. Also, the density of exposed silicon determines the selectivity, therefore reducing the selectivity of the process.

Several prior art methods have been suggested to overcome the above problems in tungsten deposition. In US-A-4 751 101 ≡ EP-A-288754, the substrate, after being exposed to $WF_6$ gas to convert a limited thickness of silicon, a subsequent layer of silicon is deposited using a plasma deposition and the wafer is then again exposed to the $WF_6$ gas. These steps are repeated until the desired thickness of silicon is converted to tungsten. In US-A-4 595 608, the substrate is periodically removed from the CVD deposition environment and moisture is applied to the areas on which tungsten is not to be deposited. The substrate is then redisposed in the CVD environment. The process uses tungsten and hydrogen reduction.

The present invention is directed to a method for depositing a non-self-limiting layer of tungsten on a semiconductor substrate comprising providing at least one area of silicon material essentially free of $SiO_2$ having a predetermined thickness on a substrate exposing said at least one area of silicon material to a gas flow consisting essentially of tungsten hexafluoridein a chemical vapor deposition (CVD) environment defined by CVD process parameters to convert a layer of said silicon material to tungsten, said layer becoming increasingly thick as the conversion proceeds; and adjusting one or more of said tungsten hexafluoride gas flow and said CVD process parameters including adjusting the temperature in the range of 300-500°C, adjusting the total pressure between 266.6 and 2666.4 $\mu$bar, adjusting the partial pressure of the tungsten hexafluoride gas in the range of 26.67 - 1066.6 $\mu$bar and adjusting the inert carrier gas flow rate between 50 and 100 SCCM such that the conversion of the silicon material is not limited by the increasing thickness of said tungsten layer.

The method can be utilized to make semiconductor devices and metal interconnects between chip layers and may be utilized for planarization of via holes used for multi-level interconnects. In a novel semiconductor structure utilizing the inventive process, the source, drain and gate silicon is converted to tungsten in one step. The tungsten gate has a midgap work function and low resistivity making the device particularly useful for sub-half micron MOS devices.

In accordance with the method of making a semiconductor device, the substrate of silicon material is provided having a surface defining drain and source regions and a silicon gate having top, bottom and sidewalls of an insulator layer material disposed on the substrate surface adjacent the drain and source regions. In addition, recessed isolation regions are disposed adjacent the source and drain regions spaced from the silicon gate. The use of polysilicon for the gate material is well known, however, the present invention may also utilize single crystalline silicon or amorphous silicon. Silicon is selectively deposited on the source and drain regions by any suitable method, such as selective epitaxial growth. The top insulator layer of the gate is then removed by RIE or a wet etch process.

Thereafter, the substrate is exposed to the tungsten hexafluoride gas flow in a chemical vapor deposition environment and the gas flow rate and the CVD process parameters are adjusted to convert the silicon gate and the source and drain silicon to tungsten, up to the entire thickness of the silicon material if desired. In one embodiment, sidewall spacers of insulator material are selectively deposited on the source and drain silicon layers prior to exposing the substrate to the CVD process.

The thickness of the silicon on the source and drain regions should be substantially the same as the thickness of the silicon gate if a midgap gate work function is desired. The height differential between the source, drain and gate silicon material would result only from the gate oxide layer between the gate and the substrate. Thus, upon conversion of the entire thickness of the source-drain silicon regions, all of the silicon gate will be converted.

Alternatively, the source and drain silicon may be grown to a thickness less than the thickness of the silicon gate. In this embodiment, only part of the silicon gate will be converted to tungsten upon conversion of the entire source and drain regions.

The process of the present invention permits semiconductor devices to be made without the prior art problems of encroachment and bridging. By avoiding the use of hydrogen in the reduction process, the problem of etching the recessed oxide isolation regions is also eliminated. The process is easily implemented in standard CVD process systems.

Figs.1-6     are cross-sectional representations of a MOS wafer showing sequentially the major fabrication steps employed in implementing the present invention.

Fig. 7     is a graph showing the relationship between the tungsten thickness and the total pressure of the CVD environment.

Fig. 8     is a graph showing the relationship between the tungsten thickness and the total carrier gas flow rate.

Fig. 9     is a graph showing the relationship between the tungsten thickness and the temperature of the CVD environment.

Fig. 10     is a graph showing the relationship between the tungsten thickness and the deposition time.

Fig. 11     is a photograph of the conversion of a multi-level interconnect via to tungsten.

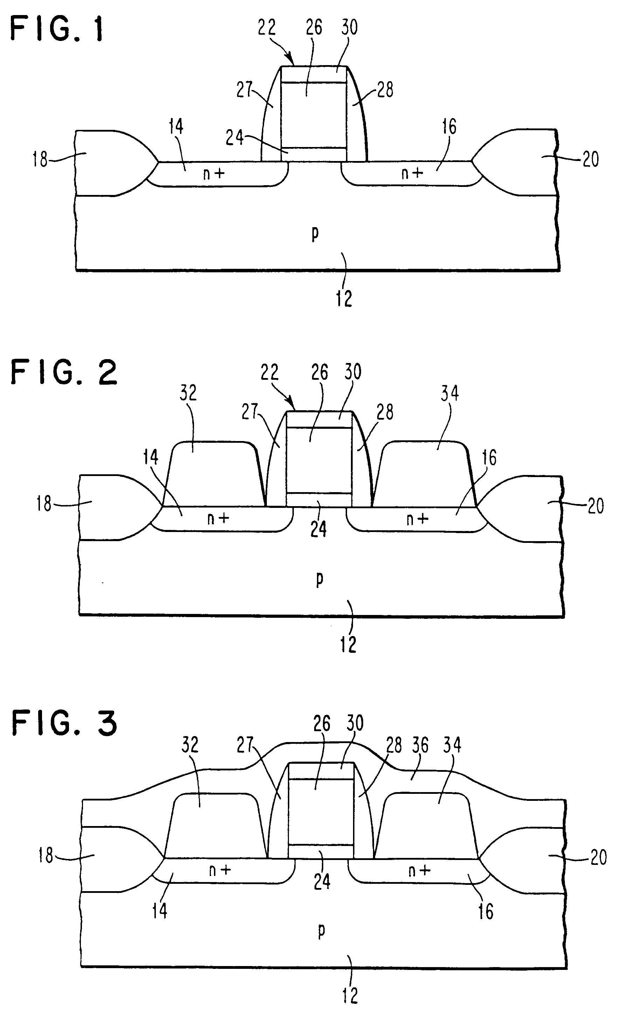

Referring now to the drawings, Fig. 1 shows a silicon wafer after gate delineation using standard CMOS fabrication processes. The wafer includes a silicon substrate 12 and source and drain regions 14 and 16. The silicon substrate is shown having p-conductivity and the source and drain regions having n+ conductivity. However, a p+ source and drain and n substrate may also be utilized. The wafer also includes recessed isolation regions 18 and 20 which may be formed with silicon oxide or silicon nitride. Gate region 22 includes a gate oxide layer 24 and a silicon gate layer 26. The gate region 22 also includes sidewalls 27 and 28 and top wall 30 made of an insulator material such as $SiO_2$ or $Si_3N_4$. The silicon used for the substrate 12 and the gate layer 26 may be any of the silicon structures of single crystal silicon, polycrystalline silicon or amorphous silicon. In the preferred embodiment, substrate 12 is single crystal silicon and the gate layer 26 is polycrystalline silicon. Typically, the gate oxide region 24 is about 12.5 nm thick. The gate silicon is about 400 nm thick and the sidewall and spacers are about 150 nm wide. The top wall layer is typically about 20 nm thick. The above dimensions are provided for example only as any suitable configuration may be used in the inventive process.

As shown in Fig. 2, source and drain silicon layers 32 and 34 are grown onto source and drain regions 14 and 16. The source and drain silicon regions 32 and 34 are preferably selectively epitaxially grown, however, they may be grown by any known manner. As shown in Fig. 3, a blanket layer 36 of insulator material, such as $SiO_2$ or $Si_3N_4$, is deposited over the entire substrate.

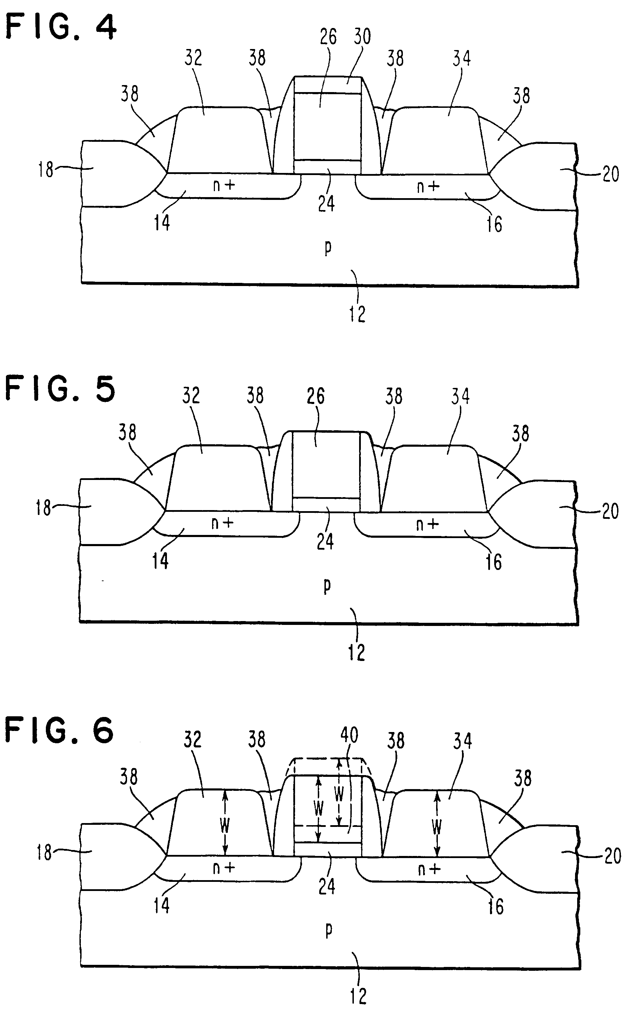

The blanket layer 36 is then selectively etched by, for example, reactive ion etching in order to leave sidewall spacers 38 for the silicon source and drain layers 32 and 34 as shown in Fig. 4. The top insulator layer 30 is then removed by RIE or chemical wet etch to leave the structure shown in Fig. 5.

The structure is then exposed to a tungsten hexafluoride gas flow in a chemical vapor deposition environment in order to convert the silicon areas 26, 32 and 34 to tungsten. As shown in Fig. 6, regions 26, 32 and 34 are completely converted to tungsten.

The total conversion of regions 26, 32 and 34 may be accomplished when the thicknesses of each of the regions are substantially the same. The resulting device, having a height differential between the source-drain and the gate defined only by the gate oxide layer has been determined to exhibit a midgap gate work function. The midgap work function results in desired threshold voltages of ± .6V, without the need for channel implants into n or p-channel devices. This avoids the inferior buried-channel operation of PMOS and at the same time yields a higher mobility and transconductance for NMOS.

However, it may be desirable to convert only a portion of the gate silicon to tungsten. In this embodiment, the thickness of the silicon deposited on the source and drain regions is less than the gate silicon. The conversion process is then performed so as to convert the entire source and drain silicon regions to tungsten and a corresponding thickness of the gate silicon. An example of the embodiment is shown in phantom in Fig. 6, where it can be seen that the silicon portion 40 is not converted.

The process for converting the selected silicon areas on the substrate utilizes silicon reduction of a tungsten hexafluoride gas. It is well known that silicon may be reduced to tungsten in accordance with the following equation:

$$2WF_6 + 3Si \rightarrow 2W + 3SiF_4 \uparrow \quad (1)$$

Tungsten has been shown to be especially useful for metallization of contacts because of its barrier properties and low contact resistance with silicon. In the present invention, the source, drain and gate are metallized with tungsten in a single step. The tungsten gate provides a midgap work function of approximately 4.8 eV.

The inventor has determined that by adjusting one or more of the tungsten hexafluoride gas flow rate and other CVD process parameters such as temperature, total pressure, partial pressure of the $WF_6$ gas and the carrier gas flow rate, that the silicon reduction of tungsten is not self limiting as shown in the prior art. Thus, the total thickness of the gate, source and drain silicon layers can be converted to tungsten in a single step.

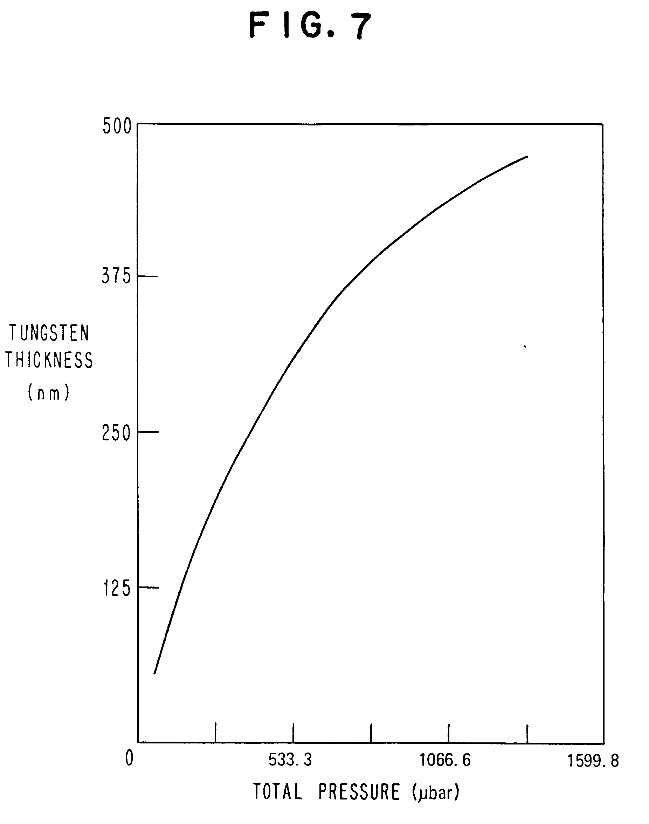

Reference is now made to the graph of Fig. 7 showing the total pressure in $\mu$bar versus the thickness of silicon converted to tungsten in nanometers. The pressure and thickness data was taken in an example in which the $WF_6$ flow rate was 15 SCCM and the carrier gas flow rate was 100 SCCM. The CVD environment temperature was 370°C and the deposition time was five minutes. The graph of Fig. 7 shows that as the total pressure is increased, the thickness of the tungsten also increased. It has been found that the suitable range of total pressure is between 266.6 (200 mT) and 2666.4 $\mu$bar (2,000 mT).

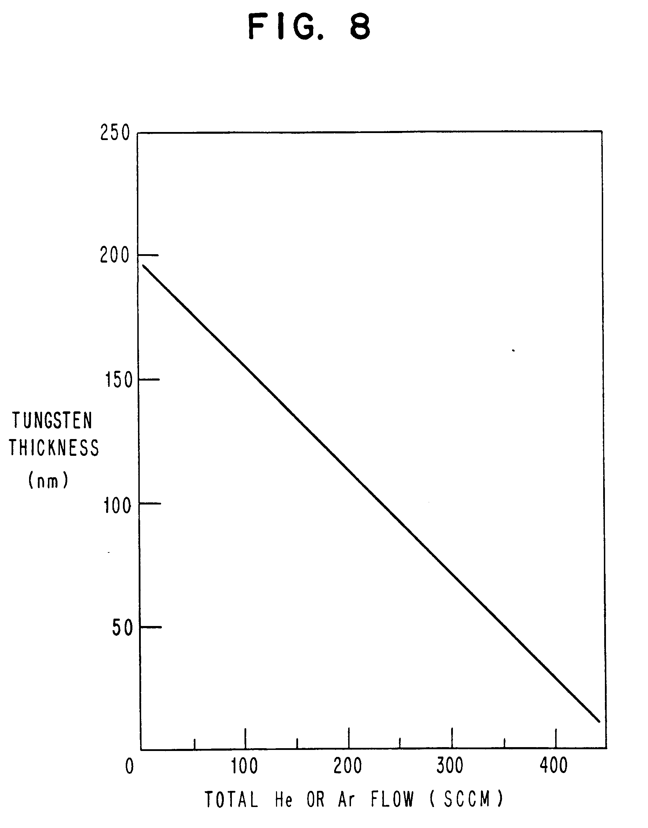

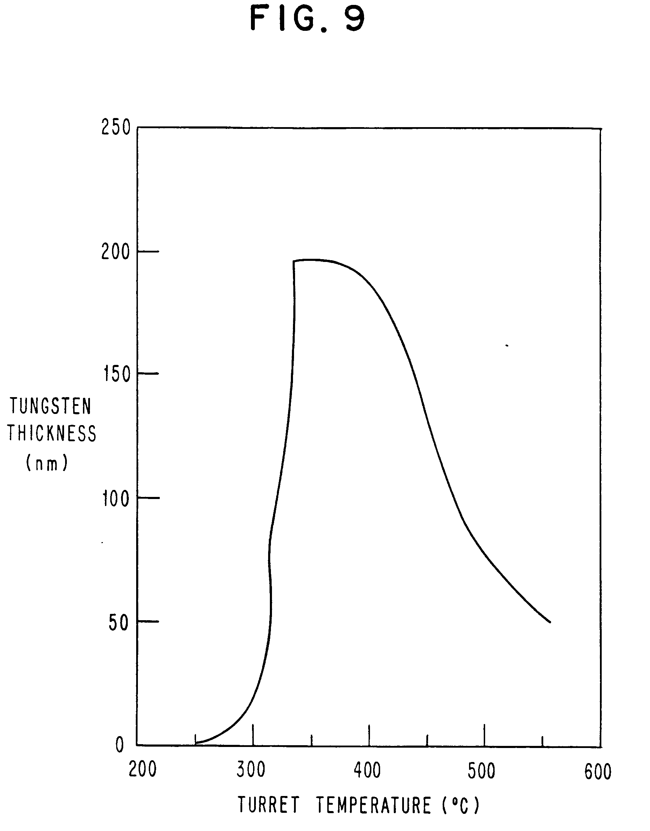

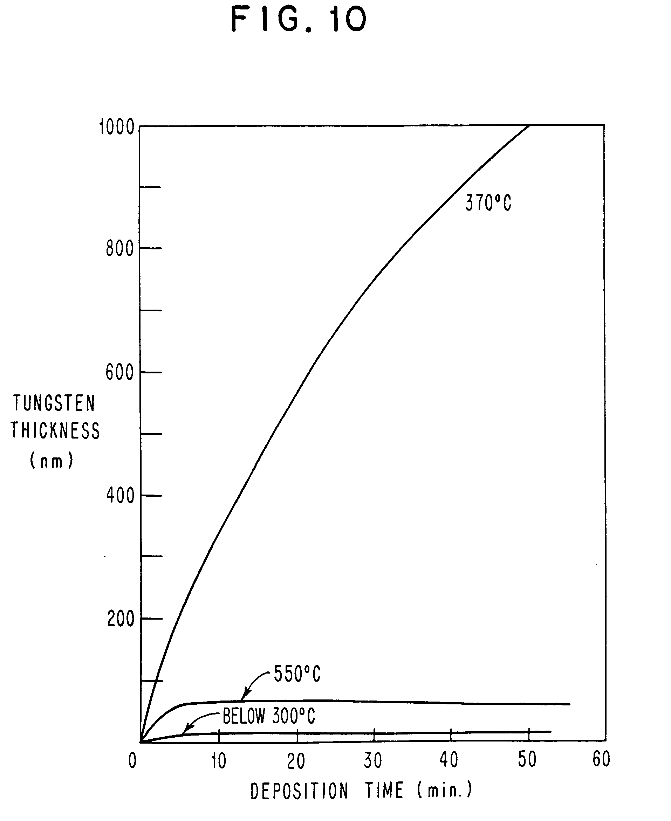

Fig. 8 shows the relationship between the carrier gas flow rate in SCCM and the tungsten thickness in nanometers. In this example the $WF_6$ flow rate was 15 SCCM, the total pressure was 266.6 $\mu$bar (200 mT), the deposition time was five minutes and the temperature was 370°C. The graph of Fig. 8 shows that as the flow rate increased the thickness decreased. The range of carrier gas flow rate is, therefore, between 50 and 100 SCCM. Fig. 9 shows the relationship between the temperature in degrees centigrade and the tungsten thickness. In this example, the $WF_6$ flow rate was 15 SCCM, the carrier gas was 100 SCCM, the pressure was 266.6 $\mu$bar (200 mT) and deposition time was five minutes. The graph of Fig. 9 shows that the temperature range is between 300 or 500°C. Fig. 10 shows the relationship between the deposition time in minutes and the tungsten thickness. In this example, the $WF_6$ flow rate was 15 SCCM, the carrier gas flow rate was 100 SCCM, the pressure was 266.6 $\mu$bar (200 mT) and temperature was 370°C. As can be seen, as the time increased the thickness of the tungsten also increased. Also shown in Fig. 10 are tests taken with the temperature below 300°C. and at 550°C., which show that the thickness failed to increase upon increase of the deposition time. The $WF_6$ flow rate has been determined to be within the range of 10 to 40 SCCM with the preferred range being between 15 and 30 SCCM.

The partial pressure of the tungsten hexafluoride gas may be determined in accordance with the following formula:

$$P_{WF_6} = P_T \quad x \quad \left[ \frac{S_{WF_6}}{S_{WF_6} + S_{He}} \right] \quad (3)$$

As can be seen in equation (3), the partial pressure is a function of the total pressure of the CVD environment and the tungsten hexafluoride and carrier gas, such as helium or argon, flow rates.

By calculation in accordance with equation (3), it can be determined that the partial pressure of the $WF_6$ gas is preferably within the range of 26.67 $\mu$bar to 1066.6 $\mu$bar (20 mT to 800 mT).

Thus, it has been shown that the tungsten thickness is the function of total pressure of tungsten hexafluoride gas flow. In addition, the tungsten thickness is also a function of the carrier gas flow rate, the temperature and the deposition time. Hence, it can be seen that by adjusting the partial pressure of the $WF_6$ gas, the thickness of the silicon converted to tungsten can be controlled so that part or all of the silicon source, drain and gate layers can be converted to tungsten.

After the conversion to tungsten, the structure can be annealed in forming gas or pure hydrogen below 900°C for shallow junctions to reduce fluorine and oxygen in the film.

After this step, routine oxide deposition and Al-Cu-Si metallization is performed for adding the ohmic contacts. For deep junctions, annealing can be performed above 1,000°C. Very little tungsten silicide is formed at these high temperatures. A possible reason for this is the incorporation of oxygen in the film which prevents silicide formation. Since epi-silicon is deposited on Si (100) the silicon consumption can be kept as low as possible, to reduce the contact resistance. The variation in sheet resistance is less than 5-6%. The process of the present invention has excellent reproduceability. The growth rate is approximately 100 to 200 nm per minute which is two orders of magnitude higher than the hydrogen reduction method for the same temperature. The resulting structure has a unique grain size of less than 10 nm.

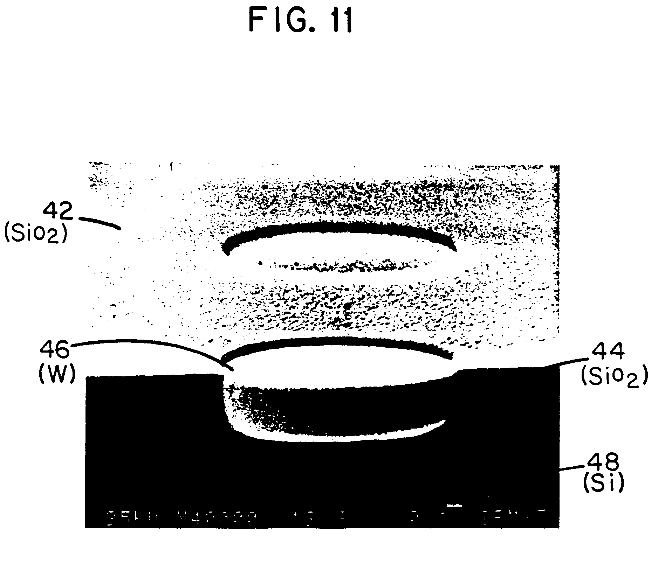

The method of the present invention is also applicable to the planarization of vias for multi-level metal interconnects. The vias in a silicon oxide layer would first be filled with polysilicon and then exposed to the silicon reduction method of the present invention. The entire thickness of the vias can easily be converted to tungsten in a one step process. Fig. 11 is a photograph of a multi-level interconnect having $SiO_2$ levels 42 and 44 and an interconnect via 46. The via 46 was first filled with polysilicon and then converted to tungsten in accordance with the inventive process described above. The photograph shows that the entire via was converted to tungsten.

The method of the present invention makes it possible to easily convert source, drain and gate polysilicon to tungsten in one step without the prior art problems of encroachment or bridging. The resulting midgap gate semiconductor structure can be used for sub-half micron MOS devices. There is minimal differential height between the metallized source and drain. This topography simplifies the planarization of passivation layers. The process is 100% selective, thermally stable and results in low contact and sheet resistance for the structure. The process is reproduceable with a high growth rate of tungsten metallization for shallow junctions. By adjusting the process parameters, any desired thickness of silicon can be converted to tungsten utilizing a standard LPCVD cold wall reactor.

**Claims**

1. A method of deposition a non-self-limiting layer of tungsten on a semiconductor substrate comprising
   providing at least one area of silicon material essentially free of $SiO_2$ having a predetermined thickness on a substrate
   exposing said at least one area of silicon material to a gas flow consisting essentially of tungsten hexafluoridein a chemical vapor deposition (CVD) environment defined by CVD process parameters to convert a layer of said silicon material to tungsten, said layer becoming increasingly thick as the conversion proceeds; and
   adjusting one or more of said tungsten hexafluoride gas flow and said CVD process parameters including adjusting the temperature in the range of 300-500°C, adjusting the total pressure between 266.6 and 2666.4 µbar, adjusting the partial pressure of the tungsten hexafluoride gas in the range of 26.67 - 1066.6 µbar and adjusting the inert carrier gas flow rate between 50 and 100 SCCM such that the conversion of the silicon material is not limited by the increasing thickness of said tungsten layer.

2. Method of claim 1 wherein said predetermined thickness is greater than the critical thickness of about 20 nm.

3. Method of claim 1 wherein the $WF_6$ gas flow rate is between 10-40 SCCM.

4. Method of claim 1 wherein the at least one area of silicon is selected from the group of single crystal silicon, polycrystalline silicon and amorphous silicon.

5. Method of making a semiconductor device, comprising:
   providing a substrate of silicon having surface defining drain and source regions, a silicon gate of a first predetermined thickness having top, bottom and sidewalls of an insulator material disposed on said substrate surface adjacent said drain and source regions and recessed isolation regions disposed adjacent said source and drain regions spaced from that silicon gate;
   selectively depositing source and drain silicon of a second predetermined thickness on said source and drain regions respectively;
   removing said insulator material top wall from said silicon gate such that the remaining surface is essentially free of $SiO_2$;

6

exposing said substrate to gas flow consisting of a tungsten hexafluoride in a chemical vapor deposition environment defined by CVD process parameters; and

adjusting one or more of said tungsten hexafluoride gas flow rate and said CVD process parameters including adjusting the temperature in the range of 300-500°C, adjusting the total pressure between 266.6 and 2666.4 $\mu$bar, adjusting the partial pressure of the tungsten hexafluoride gas in the range of 26.67 - 1066.6 $\mu$bar and adjusting the inert carrier gas flow rate between 50 and 100 SCCM to convert said silicon gate and said source and drain silicon to tungsten up to said first and second predetermined thickness.

6. Method of claim 5 wherein said substrate is single crystal silicon and said silicon gate and said source and drain silicon layers are polycrystalline silicon.

7. Method of claim 5 or 6 further including the steps of selectively depositing spacers of insulator material in the interface areas between the isolation regions and the source and drain silicon layers and between the silicon gate and the source and drain silicon layers prior to exposing the substrate to tungsten hexafluoride gas flow.

8. Method of any one of claims 5 to 7 wherein said insulator material and said isolation regions are selected from the group of $SiO_2$ and $Si_3N_4$.

9. Method of claim 7 or 8 wherein the insulator spacers are selectively deposited by depositing a blanket layer of insulator material over the entire substrate, and etching said blanket layer while leaving a portion of said insulator layer in said interface areas.

10. Method of any one of claims 5 to 9 wherein the first and second predetermined thicknesses are substantially the same or the second predetermined thickness is less than the first predetermined thickness.

11. Method of claim 1 wherein the at least one area of silicon material is provided by filling one or more vias of said predetermined thickness in an oxide layer disposed on a conducting substrate and whereby the silicon in the one or more vias is converted to tungsten up to said predetermined thickness.

12. Metal oxide semiconductor device comprising:
a semiconductor layer of a first conductivity type;
drain and source regions of a second conductivity type formed in said semiconductor layer, said drain and source regions being separated from each other;
an oxide insulating layer formed on said semiconductor layer between said source and drain regions;
a refractory metal gate layer formed on said oxide insulating layer according to anyone of claims 1 to 4, said refractory metal gate layer having sidewall spacers of an insulating material;
source and drain refractory metal layers formed on said source and drain regions respectively, said source and drain refractory metal layers having sidewall spacers of an insulating material; and
ohmic contacts formed on said source and drain refractory metal layers.

**Patentansprüche**

1. Verfahren zur Abscheidung einer sicht nicht selbstbegrenzenden Wolframschicht auf einem Halbleitersubstrat, das folgende Schritte umfaßt:
Aufbringen von mindestens einer Fläche aus Silicium-Material auf einem Substrat, die praktisch frei von $SiO_2$ ist und eine festgelegte Dicke hat;
Einbringen der mindestens einen Fläche aus Silicium-Material in einen hauptsächlich aus Wolframhexafluorid bestehenden Gasstrom unter den durch die CVD-Verfahrensparameter festgelegten Umgebungsbedingungen einer chemischen Abscheidung aus der Dampfphase (CVD), um eine Schicht des Silicium-Materials durch Wolfram zu ersetzen, wobei die Schicht mit fortschreitendem Austausch an Dicke zunimmt; und
Einstellen eines oder mehrerer Parameter für den Wolframhexafluorid-Gasstrom und der CVD-Verfahrensparameter einschließlich Einstellen der Temperatur im Bereich zwischen 300 und 500°C, Einstellen des Gesamtdrucks zwischen 266,6 und 2666,4 $\mu$bar, Einstellen des Partialdrucks des Wolframhexafluoridgases im Bereich 26,67 - 1066,6 $\mu$bar und Einstellen der Strömungsgeschwindigkeit des inerten Trägergases zwischen 50 und 100 SCCM (Standardkubikzentimeter pro Minute), so daß sich der Austausch des Silicium-Materials durch die zunehmende Dicke der Wolframschicht nicht selbst begrenzt.

2. Verfahren gemäß Anspruch 1, wobei die festgelegte Dicke größer als die kritische Dicke von etwa 20 nm ist.

3. Verfahren gemäß Anspruch 1, wobei die Strömungsrate des $WF_6$-Gases zwischen 10 und 40 SCCM (Standardkubikzentimeter pro Minute) liegt.

4. Verfahren gemäß Anspruch 1, wobei die mindestens eine Siliciumfläche aus der Gruppe bestehend aus einkristallinem Silicium, polykristallinem Silicium und amorphem Silicium ausgewählt wird.

5. Verfahren zum Herstellen eines Halbleiterbausteins, das folgende Schritte umfaßt:
Herstellen eines Substrats aus Silicium, das eine Drain- und Source-Bereiche bildende Oberfläche, ein Silicium-Gate mit einer ersten festgelegten Dicke und oberen, unteren und Seitenwänden aus einem Isolatormaterial, das sich auf der Substratoberfläche neben den Source- und Drain-Bereichen befindet, und ausgebuchtete Isolationsbereiche hat, die neben den Source- und Drain-Bereichen liegen und einen Abstand zum Silicium-Gate besitzen;
selektives Abscheiden von Source- bzw. Drain-Silicium mit einer zweiten festgelegten Dicke auf den Source- bzw. Drain-Bereichen;
Entfernen der oberen Wand aus Isolatormaterial vom Silicium-Gate auf eine Weise, daß die verbleibende Oberfläche im wesentlichen frei von $SiO_2$ ist;
Einbringen des Substrats in einen aus Wolframhexafluorid bestehenden Gasstrom in einer durch CVD-Verfahrensparameter festgelegten Umgebung für eine chemische Abscheidung aus der Dampfphase; und
Einstellen eines oder mehrerer Parameter für den Wolframhexafluorid-Gasstrom und der CVD-Verfahrensparameter einschließlich Einstellen der Temperatur im Bereich zwischen 300 und 500 °C, Einstellen des Gesamtdrucks zwischen 266,6 und 2666,4 $\mu$bar, Einstellen des Partialdrucks des Wolframhexafluoridgases im Bereich 26,67 - 1066,6 $\mu$bar und Einstellen der Strömungsgeschwindigkeit des inerten Trägergases zwischen 50 und 100 SCCM (Standardkubikzentimeter pro Minute), um das Silicium-Gate und das Source- und Drain-Silicium bis zu der ersten und zweiten festgelegten Dicke durch Wolfram zu ersetzen.

6. Verfahren gemäß Anspruch 5, wobei das Substrat aus einkristallinem Silicium und das Silicium-Gate sowie die Source- und Drain-Bereiche aus polykristallinem Silicium bestehen.

7. Verfahren gemäß Anspruch 5 oder 6, das ferner einen Schritt enthält, durch den vor dem Einbringen des Substrats in den Gasstrom aus Wolframhexafluorid Abstandsstücke aus Isolatormaterial selektiv zwischen den Isolatorbereichen und den Source- und Drain-Siliciumschichten und zwischen dem Silicium-Gate und den Source- und Drain-Siliciumschichten abgeschieden werden.

8. Verfahren gemäß einem der Ansprüche 5 bis 7, wobei das Isolatormaterial und die Isolatorbereiche aus der Gruppe bestehend aus $SiO_2$ und $Si_3N_4$ ausgewählt werden.

9. Verfahren gemäß Anspruch 7 oder 8, wobei die Isolator-Abstandsstücke durch Abscheiden einer Deckschicht über dem gesamten Substrat und durch Ätzen der Deckschicht unter Erhaltung eines Teils der Isolatorschicht in den Zwischenbereichen selektiv abgeschieden werden.

10. Verfahren gemäß einem der Ansprüche 5 bis 9, wobei die erste und zweite festgelegte Dicke praktisch gleich sind oder die zweite festgelegte Dicke kleiner als die erste festgelegte Dicke ist.

11. Verfahren gemäß Anspruch 1, wobei die mindestens eine Fläche aus Silicium-Material durch Füllen von einem oder mehreren Durchgangslöchern mit der festgelegten Dicke in einer auf einem leitenden Substrat befindlichen Oxidschicht hergestellt wird und wobei das Silicium in dem einen oder in mehreren Durchgangslöchern bis zu der festgelegten Dicke durch Wolfram ersetzt wird.

**12.** Metalloxid-Halbleiterbaustein mit:

einer Halbleiterschicht eines ersten Leitungstyps;

in der Halbleiterschicht gebildeten Drain- und Source-Bereichen eines zweiten Leitungstyps, wobei die Source- und Drain-Bereiche voneinander getrennt sind;

einer Oxid-Isolationsschicht, die auf der Halbleiterschicht zwischen den Source- und Drain-Bereichen gebildet wird;

einer Gate-Schicht aus hochschmelzendem Metall, die gemäß einem der Ansprüche 1 bis 4 auf der Oxid-Isolationsschicht hergestellt wird, wobei die Gate-Schicht aus hochschmelzendem Metall an den Seitenwänden Abstandsstücke aus einem Isolatormaterial besitzt;

Source- und Drain-Schichten aus hochschmelzendem Metall, die auf den Source- bzw. Drain-Bereichen hergestellt werden, wobei die Source- und Drain-Schichten aus hochschmelzendem Metall an den Seitenwänden Abstandsstücke aus einem Isolatormaterial besitzen; und

Ohmschen Kontakten, die auf den Source- und Drain-Schichten aus hochschmelzendem Metall gebildet werden.

**Revendications**

**1.** Méthode de dépôt d'une couche non auto-limitative de tungstène sur un substrat semi-conducteur comprenant :

réaliser au moins une zone de matériau de silicium essentiellement exempte de $SiO_2$ ayant une épaisseur prédéterminée sur un substrat,

exposer ladite au moins une zone de matériau de silicium à un écoulement gazeux consistant essentiellement en hexafluorure de tungstène dans un environnement de dépôt en phase vapeur chimique (CVD) défini par des paramètres de procédé CVD pour convertir une couche dudit matériau de silicium en tungstène, ladite couche devenant plus épaisse au fur et à mesure de la conversion, et

ajuster un ou plusieurs dudit écoulement gazeux d'hexafluorure de tungstène et desdits paramètres du procédé CVD incluant l'ajustement de la température dans la gamme 300-500 ° C, l'ajustement de la pression totale entre 266,6 et 2666,4 $\mu$bar, l'ajustement de la pression partielle du gaz hexafluorure de tungstène dans la gamme de 26,67 - 1066,6 $\mu$bar et l'ajustement de la vitesse de l'écoulement du gaz porteur inerte entre 50 et 100 SCCM de telle sorte que la conversion du matériau de silicium n'est pas limitée par l'épaisseur de ladite couche de tungstène.

**2.** Méthode selon la revendication 1, dans laquelle ladite épaisseur prédéterminée est supérieure à l'épaisseur critique d'environ 20 nm.

**3.** Méthode selon la revendication 1, dans laquelle la vitesse d'écoulement du gaz $WF_6$ est entre 10 et 40 SCCM.

**4.** Méthode selon la revendication 1, dans laquelle ladite au moins une zone de silicium est sélectionnée dans le groupe de silicium en cristal simple, silicium polycristallin et silicium amorphe.

**5.** Méthode de fabrication d'un dispositif semi-conducteur comprenant :

réaliser un substrat de silicium ayant une surface définissant des régions de drain et de source, une grille de silicium d'une première épaisseur prédéterminée ayant des parois supérieure, inférieure et latérale en un matériau isolant disposé sur ladite surface du substrat adjacente auxdites régions de drain et de source et des régions isolantes évidées disposées de façon adjacente auxdites régions de source et de drain espacées de la grille de silicium,

déposer sélectivement une source et un drain en silicium d'une seconde épaisseur prédéterminée sur lesdites régions de source et de drain respectivement,

retirer ladite paroi supérieure en matériau isolant de ladite grille de silicium de telle sorte que la surface restante soit essentiellement exempte de $SiO_2$,

exposer ledit substrat à un écoulement gazeux consistant en hexafluorure de tungstène dans un environnement en phase vapeur chimique défini par des paramètres CVD, et

ajuster un ou plusieurs dudit écoulement gazeux d'hexafluorure de tungstène et desdits paramètres du procédé CVD incluant l'ajustement de la température dans la gamme 300-500 ° C, l'ajustement de la pression totale entre 266,6 et 266,4 $\mu$bar, l'ajustement de la pression partielle du gaz hexafluorure de tungstène dans la gamme de 26,67 - 1066,6 $\mu$bar et l'ajustement de la vitesse de l'écoulement du gaz porteur inerte entre 50 et 100 SCCM de façon à convertir ladite grille et lesdits source et drain de

9

silicium en tungstène jusqu'auxdites première et seconde épaisseur prédéterminées.

6. Méthode selon la revendication 5, dans laquelle ledit substrat est en silicium en cristal simple et lesdites couches de silicium de grille, source et drain sont en silicium polycristallin.

7. Méthode selon la revendication 5 ou 6, comprenant en outre les étapes de déposer sélectivement des entretoises de matériau isolant dans les zones d'interface entre les régions isolantes et les couches de silicium de source et drain et entre la grille de silicium et les couches de silicium de source et drain avant d'exposer le substrat à l'écoulement gazeux d'hexafluorure.

8. Méthode selon l'une quelconque des revendications 5 à 7, dans laquelle ledit matériau isolant et lesdites régions isolantes sont choisis à partir du groupe de $SiO_2$ et $Si_3N_4$.

9. Méthode selon la revendication 7 ou 8, dans laquelle les entretoises isolantes sont faites sélectivement en déposant une couche de couverture de matériau isolant sur le substrat entier, et en gravant ladite couche de couverture tout en laissant une portion de ladite couche isolante dans lesdites zones et interface.

10. Méthode selon l'une quelconque des revendications 5 à 9, dans laquelle les première et seconde épaisseurs prédéterminées sont substantiellement les mêmes, ou bien la seconde épaisseur prédéterminée est inférieure à la première épaisseur prédéterminée.

11. Méthode selon la revendication 1, dans laquelle ladite au moins une zone de matériau de silicium est réalisée en remplissant un ou plusieurs trous de connexion de ladite épaisseur prédéterminée d'une couche d'oxyde disposée sur un substrat conducteur et dans laquelle le silicium dans le ou les trous de connexion est converti en tungstène jusqu'à ladite épaisseur prédéterminée.

12. Dispositif semi-conducteur métal-oxyde comprenant :
une couche semi-conductrice d'un premier type de conductivité,
des régions de drain et source d'un second type de conductivité formées dans ladite couche semi-conductrice, lesdites régions de drain et source étant séparées l'une de l'autre,
une couche isolante d'oxyde formée sur ladite couche semi-conductrice entre lesdites régions de source et drain,
une couche de grille en métal réfractaire formée sur ladite couche isolante d'oxyde selon l'une quelconque des revendications 1 à 4, ladite couche de grille en métal réfractaire ayant des entretoises de paroi en matériau isolant,
des couches de métal réfractaire de source et drain formées respectivement sur lesdites régions de source et drain, lesdites couches de métal réfractaire de source et drain ayant des entretoises de paroi en matériau isolant, et
des contacts ohmiques formés sur lesdites couches de métal réfractaire de source et drain.

# FIG. 1

# FIG. 2

# FIG. 3

**FIG. 4**

**FIG. 5**

**FIG. 6**

# F I G. 7

# FIG. 8

# FIG. 9

# FIG. 10

# FIG. 11

42
(SiO$_2$)

46
(W)

44
(SiO$_2$)

48
(Si)